**Europäisches Patentamt**

**European Patent Office**

**Office européen des brevets**

(11) Veröffentlichungsnummer : **0 189 787**
**B1**

(12) EUROPÄISCHE PATENTSCHRIFT

(45) Veröffentlichungstag der Patentschrift :
05.04.89

(51) Int. Cl.⁴ : **H 05 K 7/18**

(21) Anmeldenummer : **86100519.7**

(22) Anmeldetag : **16.01.86**

(54) Vorrichtung zur Befestigung von Wandverkleidungsteilen an Gerätegestellen.

(30) Priorität : **28.01.85 DE 3502784**

(43) Veröffentlichungstag der Anmeldung :
**06.08.86 Patentblatt 86/32**

(45) Bekanntmachung des Hinweises auf die Patenterteilung : **05.04.89 Patentblatt 89/14**

(84) Benannte Vertragsstaaten :
**AT BE CH DE FR GB IT LI NL SE**

(56) Entgegenhaltungen :
**DE--A-- 1 554 473**
**DE--A-- 2 832 575**
**US--A-- 2 831 745**
**US--A-- 3 055 462**

(73) Patentinhaber : **Siemens Aktiengesellschaft Berlin und München**
**Wittelsbacherplatz 2**
**D-8000 München 2 (DE)** ,

(72) Erfinder : **Moser, Erich**
**Dorfstrasse 8**
**D-8028 Taufkirchen (DE)**

Jouve, 18, rue St-Denis, 75001 Paris, France

EP 0 189 787 B1

## Beschreibung

Die Erfindung betrifft eine Vorrichtung zur Befestigung von Wandverkleidungsteilen an Gerätegestellen nach dem Oberbegriff des Patentanspruchs 1. Solche Vorrichtungen sind beispielsweise aus DE-A-1 554 473 und DE-A-2 832 575 bekannt.

Wandverkleidungen an elektrischen Geräten erfüllen nicht nur einen ästhetischen Zweck, sie sollen auch den Benutzer aus Sicherheitsgründen vor einer unmittelbaren Berührung mit dem Gestell des Gerätes schützen. Diese Wandverkleidungen müssen deshalb so befestigt werden, daß sie von außen nicht ohne weiteres entfernt werden können. Dennoch soll die Befestigungsvorrichtung aus Wartungsgründen so gestaltet sein, daß die Verkleidung im Bedarfsfall sehr schnell und einfach entfernt werden kann.

Aus der US-A-3 055 462 ist eine Vorrichtung zur Befestigung von Streben mit U-Form bekannt, wobei ein Befestigungswinkel mit einer Winkelseite auf der Stirnseite einer Strebe geschweisst wird und wobei auf der anderen Winkelseite zwei Ansatzschrauben und eine Blattfeder vorgesehen sind, die in langlochartige, sich verjüngende Aussparungen in der anderen Strebe greifen, so daß die Blattfeder das Zurückschieben der Ansatzschrauben verhindert.

Der vorliegenden Erfindung liegt deshalb die Aufgabe zugrunde, eine Befestigungsvorrichtung für Wandverkleidungen an Gerätegestellen so auszugestalten, daß die an mehreren Stellen des Gerätes arretiert Wandverkleidung mit einem einzigen Handgriff und ohne Werkzeug vom Gestell entfernt werden kann.

Die Lösung dieser Aufgabe ergibt sich erfindungsgemäß durch die kennzeichnenden Merkmale des Patentanspruchs 1.

Vorteilhafte Weiterbildungen der Erfindung sind in den Unteransprüchen angegeben.

Im folgenden wird ein Ausführungsbeispiel der Erfindung anhand der Zeichnung näher erläutert. Dabei zeigen

Fig. 1 eine Gehäusefläche, von innen gesehen, mit einem daran befestigten Wandverkleidungsteil unter Verwendung erfindungsgemäß ausgebildeter Befestigungsvorrichtungen,

Fig. 2, 3 je eine Schnittdarstellung längs der Schnittlinie II-II bzw. III-III, und zwar in einem ersten Montageschritt und in der endgültig eingerasteten Stellung der Befestigungsvorrichtung.

Fig. 4 eine Einzelheit im Bereich einer am unteren Gestellrand vorgesehenen Befestigungsvorrichtung.

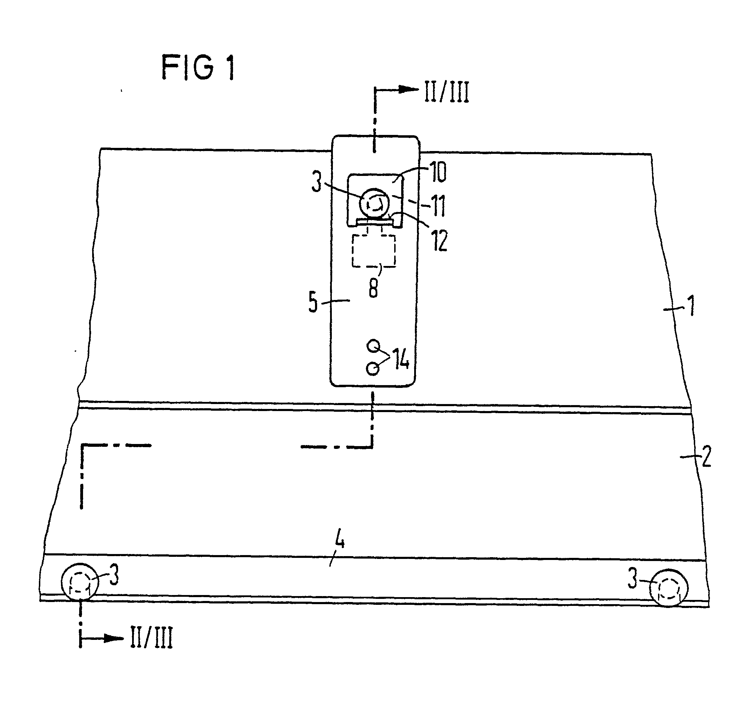

Die Fig. 1 zeigt einen Ausschnitt aus der Gestellseitenfläche 1, von innen gesehen, an deren Außenseite eine Wandverkleidung 2 befestigt ist. Zu diesem Zweck sind an der dem Gestell zugewandten Seite der Wandverkleidung 2 mehrere mit einem kurzen Hals abstehende Ansatzschrauben 3 vorgesehen, deren eine Zylinderform aufweisender Kopf in Aussparungen der Gestellseitenfläche 1 bzw. des unteren Gestellrahmens 4 eintaucht. Die Ansatzschrauben sind zweckmäßig so über die Wandverkleidung verteilt, daß sich wie aus Fig. 1 ersichtlich, eine Dreiecksform ergibt, wobei die an der oberen Dreickspitze vorgesehene Ansatzschraube zusätzlich durch ein Rastelement in Form einer Blattfeder 5 gesichert ist. Diese Blattfeder 5 ist unterhalb der Aussparung mittels zweier Nieten 14 an der Innenseite der Gestellseitenfläche 1 befestigt, und reicht mit dem freien Ende nach oben über den Gestellrand hinaus, wobei das darüber hinausreichende Endstück als Griffelement dient.

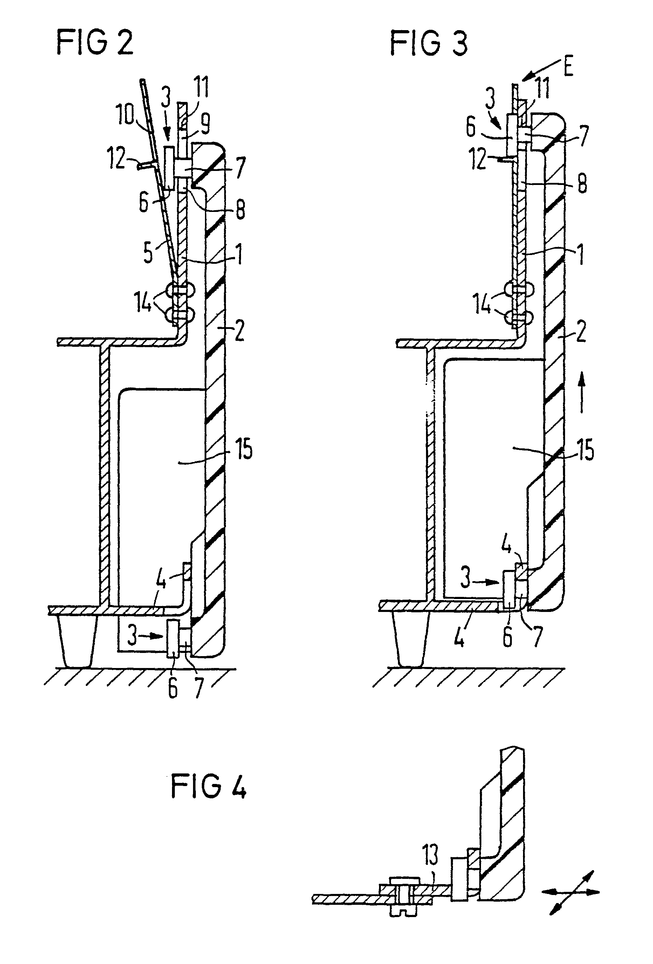

Nähere Einzelheiten der Anordnung gemäß Fig. 1 sind aus den in den Figuren 2 und 3 gezeigten Schnittdarstellungen ersichtlich. Sie zeigen die Wandverkleidung 2 mit den am oberen und unteren Rand vorgesehenen jeweils nach innen gerichteten Ansatzschrauben 3. Der Kopf 6 dieser mit einem kurzen Hals 7 abstehenden Ansatzschrauben ist beispielsweise zylinderförmig ausgebildet. Als Gegenstück zu den Ansatzschrauben 3 sind an der Gestellseitenfläche 1 bzw. am unteren Gestellrahmen 4 an entsprechender Stelle Aussparungen vorgesehen. Die am oberen Gestellrand vorgesehene langlochähnliche Aussparung 8 besteht aus einem unteren Bereich, der in Größe und Abmessung an den dort eintauchenden Kopf 6 der Ansatzschraube 3 angepaßt ist und aus einer nach oben gerichteten zungenartigen Verjüngung 9 mit einer der Dicke des Schraubenhalses 7 entsprechenden Breite. Die Aussparungen im unteren Gestellrahmen 4 bestehen lediglich aus den nach unten offenen zungenartigen Verjüngungen, Ansatzschrauben von unten her zugeführt werden können.

Die Montage erfolgt nun z. B. bei einem auf Füßen stehenden Gestell in der Weise, daß die auf der Unterkante stehende Wandverkleidung 2 gegen die Gestellfläche 1 gedrückt wird, wobei die unteren Ansatzschrauben 3 unterhalb des Gestellrahmens 4 und die obere Ansatzschraube in die in der Gestellseitenfläche 1 vorgesehene Aussparung 8 eintauchen. Dabei wird der Kopf 6 der oberen Ansatzschraube gegen den Druck der Blattfeder 5 soweit durchgedrückt, bis der Schraubenhals 7 in die zungenartige Verjüngung 9 eingefädelt werden kann. Nun wird das Wandverkleidungsteil 2 nach oben geschoben, wobei sowohl die oberen als auch die beiden unteren Ansatzschrauben mit ihren Hälsen in der jeweiligen zungenartigen Verjüngung 9 der zugehörigen Aussparung bis zu einem oberen Anschlag 11 geführt werden. In dieser oberen Stellung taucht der Kopf 6 der oberen Ansatzschraube schließlich noch in einen in der Blattfeder 5 vorgesehenen Durchbruch 10 mit der Folge, daß die Blattfeder 5 zurückfedert und ein an der Unterkante des Durchbruches 10 vorgesehener Winkelansatz 12 unterhalb des Schraubenkopfes 6 einrastet. Der Wandverkleidungsteil 2 ist damit endgültig verriegelt.

Das Entriegeln erfolgt ohne Werkzeug mit einem einzigen Handgriff derart, daß die Blattfeder am oberhalb der Gestellseitenfläche 1 herausragenden Griffende weggedrückt wird (siehe Pfeil E), worauf das Wandverkleidungsteil 2 nach unten fällt und seitlich abgezogen werden kann. Besonders vorteilhaft ist es, wenn die am unteren Gestellrahmen 4 vorgesehenen, lediglich aus den zungenartigen Verjüngungen 9 bestehenden Aussparungen in einem am Gestellrahmen 4 verschiebbar befestigten Winkelstück 13 enthalten sind weil dann die Wandverkleidung um eine waagrechte und senkrechte Achse gekippt und damit relativ einfach nach angrenzenden Gehäuseteilen ausgerichtet werden kann.

Am Wandverkleidungsteil 2 ist ferner noch ein rechtwinklig abstehenden Ansatzelement 15 vorgesehen, das einen Teil der Gehäuserückwand bietet. Das hat den Vorteil, daß beim Abnehmen der seitlichen Wandverkleidung auch ein Teil der Geräterückwand mit dort vorgesehenen Steckeranschlüssen freigelegt wird.

## Patentansprüche

1. Vorrichtung zur Befestigung von Wandverkleidungsteilen an Gerätegestellen, unter Verwendung von ineinander greifenden Rastelementen, dadurch gekennzeichnet, daß an der dem Gestell zugewandten Seite des Wandverkleidungsteiles (2) mehrere, mit einem kurzen Hals (7) abstehende Ansatzschrauben (3) vorgesehen sind, daß das Gestell (1) an entsprechenden Stellen langlochartige Aussparungen (8) aufweist, die im unteren Bereich eine dem in diese Aussparung eintauchenden Kopf (6) der Ansatzschraube (3) angepaßte Abmessung und eine nach oben gerichtete zungenartige Verjüngung (9) mit einer der Dicke des Schraubenhalses (7) angepaßten Breite aufweist und daß für wenigstens eine am oberen Rand des Gestells vorgesehene Befestigungsvorrichtung an der dem Wandverkleidungteil (2) abgewandten Seite eine unterhalb der Aussparung (8) befestigte Blattfeder (5) vorgesehen ist, die mit dem freien Ende nach oben über den Gestellrand hinausreicht und außerdem hinter der zungenartigen Verjüngung (9) einen Druchbruch (10) aufweist, der in Größe und Lage so bemessen und angeordnet ist, daß die gegen den Druck der Blattfeder (5) mit dem Kopf (6) durch die Gestellaussparung (8) gesteckte und mit dem Schraubenhals (7) in der zungenartigen Verjüngung (9) bis zu einem oberen Anschlag (11) geführte Ansatzschraube mit dem Kopf (6) in den Durchbruch (10) der zurückfedernden Blattfeder (5) eintaucht.

2. Vorrichtung nach Anspruch 1, dadurch gekennzeichnet, daß der an der Unterkante des in die Blattfeder (5) vorgesehenen Durchbruchs (10) ein Winkelansatz (12) vorgesehen ist, der als Auflage für den Schraubkopf (6) dient.

3. Vorrichtung nach einem der Ansprüche 1 oder 2, dadurch gekennzeichnet, daß bei einem auf Füßen stehenden Gestell eine an der unteren Kante des Gestells vorgesehene Aussparung nur aus der zungenartigen, nach unten offenen Verjüngung (9) besteht.

4. Vorrichtung nach einem der vorhergehenden Ansprüche, dadurch gekennzeichnet, daß der Kopf (6) der Ansatzschraube eine zylindrische Form aufweist.

5. Vorrichtung nach Anspruch 4 dadurch gekennzeichnet, daß die an der unteren Kante des Gestells vorgesehene Aussparung in einem am Gestellboden verschiebbar befestigten Winkelstück (13) enthalten ist.

## Claims

1. Fastening device for side dress panels of equipment racks, using interlocking catch elements, characterized in that a plurality of shoulder screws (3) protruding with a short neck (7) are provided on the side of the side dress panel (2) facing the rack, that the rack (1), at corresponding locations, has slot-like recesses (8) which, in the lower area, are dimensioned so as to be adapted to the head (6) of the shoulder screw (3) plunging into this recess and have a tongue-like narrowed section (9) directed upwards and having a width adapted to the thickness of the screw neck (7), and that, for at least one fastening device provided at the upper margin of the rack, a leaf spring (5) fixed beneath the recess (8) is provided at the side remote from the side dress panel (2), which leaf spring (5), with the free end, extends up beyond the rack margin and in addition, behind the tongue-like narrowed section (9), has an aperture (10) which is dimensioned and arranged in size and position in such a way that the shoulder screw, inserted with the head (6) through the rack recess (8) against the pressure of the leaf spring (5) and guided with the screw neck (7) in the tongue-like narrowed section (9) up to an upper stop (11), plunges with the head (6) into the aperture (10) of the leaf spring (5) springing back.

2. Device according to Claim 1, characterized in that an angle extension (12) which serves as a bearing surface for the screw head (6) is provided on the lower edge of the aperture (10) provided in the leaf spring (5).

3. Device according to either of Claims 1 or 2, characterized in that, in the case of a rack standing on feet, a recess provided at the lower edge of the rack consists only of the tongue-like narrowed-section (9) open at the bottom.

4. Device according to any of the preceding claims, characterized in that the head (6) of the shoulder screw has a cylindrical shape.

5. Device according to Claim 4, characterized in that the recess provided at the lower edge of the rack is contained in an angle piece (13) displaceably fixed to the rack base.

## Revendications

1. Dispositif pour fixer des éléments de revêtements à des baies d'appareillages, avec mise en oeuvre d'éléments d'encliquetage à interpénétration, caractérisé par le fait que sur le côté de l'élément de revêtement (2) qui est tourné vers la baie, sont prévus des boulons à épaulement (3) à collerette courte et saillante, que la baie (1) comporte en des emplacements correspondants des ouvertures en forme de boutonnières (8) qui présentent, dans la partie inférieure, une dimension adaptée à la tête (6) du boulon à épaulement (3), qui pénètre dans cette ouverture, et un amincissement (6) en forme de languette dirigée vers le haut, avec une largeur adaptée à l'épaisseur de la collerette (7) du boulon, et qu'il est prévu pour au moins un dispositif de fixation, sur le bord supérieur de la baie et du côté éloigné de l'élément de revêtement (2), une lame de ressort (5) fixée en dessous de l'ouverture (8), qui déborde par l'extrémité libre le bord de la baie vers le haut et qui présente, en outre, derrière l'amincissement (9) en forme de languette, une ouverture (10) dont les dimensions et l'agencement sont tels que le boulon à épaulement qui est enfoncé par la tête (6) dans l'ouverture (8) de la baie, à l'encontre de la pression exercée par la lame de ressort, et qui est guidé par la collerette (7) du boulon dans l'amincissement en languette (9), jusqu'à une butée supérieure (11), pénètre avec sa tête (6) dans l'ouverture (10) de la lame de ressort (5) qui a tendance à revenir élastiquement dans la position initiale.

2. Dispositif selon la revendication 1, caractérisé par le fait qu'au niveau du bord inférieur de l'ouverture (10) ménagée dans la lame de ressort (5), est prévu un appendice en cornière (12) qui sert d'appui pour la tête de boulon (6).

3. Dispositif selon l'une des revendications 1 ou 2, caractérisé par le fait que dans le cas d'une baie montée sur pieds, une ouverture prévue sur le bord inférieur de la baie, n'est constituée que par l'amincissement (9), en forme de languette, ouvert vers le bas.

4. Dispositif selon l'une des revendications précédentes, caractérisé par le fait que la tête de boulon à épaulement, possède une forme cylindrique.

5. Dispositif selon la revendication 4, caractérisé par le fait que l'ouverture prévue au bord inférieur de la baie, est ménagée dans une pièce en équerre (13) fixée de façon déplaçable au fond de la baie.

FIG 1

## FIG 2

## FIG 3

## FIG 4